# FASCICULE DE BREVET EUROPEEN

(11) **EP 3 502 048 B1**
(45) Date de publication et mention de la délivrance du brevet: **16.02.2022**
(21) Numéro de dépôt: 18214906.2
(22) Date de dépôt: 20.12.2018
(51) Int. Cl.: B82Y 10/00, H01L 29/775, H01L 29/06, H01L 29/10, H01L 29/08, H01L 29/78, H01L 21/336, H01L 29/165

(54) **PROCEDE DE REALISATION DE TRANSISTOR FET A CANAL CONTRAINT**
HERSTELLUNGSVERFAHREN EINES FET-TRANSISTORS MIT VERSPANNTEM KANAL
METHOD FOR PRODUCING A FET TRANSISTOR WITH STRAINED CHANNEL

(30) Priorité: 22.12.2017 US 201715852681
(43) Date de publication de la demande: 26.06.2019
(73) Titulaire: Commissariat à l'énergie atomique et aux énergies alternatives, 75015 Paris (FR)
(72) Inventeur: REBOH, Shay, 38054 GRENOBLE Cedex 09 (FR); COQUAND, Rémi, 73800 LES MARCHES (FR)
(74) Mandataire: Brevalex

(56) Documents cités:
- US-A1- 2010 176 459
- US-A1- 2010 187 503
- US-A1- 2010 193 882
- US-A1- 2012 181 549
- US-A1- 2015 162 446
- US-A1- 2015 380 555
- US-A1- 2016 079 422

## Description

### DOMAINE TECHNIQUE ET ART ANTÉRIEUR

L'invention concerne le domaine de la réalisation de transistors FET à canal contraint. L'invention s'applique notamment à la réalisation de transistors GAAFET (« Gâte All Around Field Effect Transistor », ou transistors FET à grille enrobante), FinFET (« Fin Field Effect Transistor », dans lequel le canal est formé par un doigt, ou aileron, entouré par la grille du transistor) ou VFET (« Vertical Field Effect Transistor », ou transistor FET vertical). De manière générale, l'invention s'applique à la réalisation de transistors avantageusement destinés à des applications logiques à hautes performances et basse consommation de la microélectronique.

Les transistors de type GAAFET, FinFET et VFET font partie de la famille des transistors ayant une architecture dite 3D. Dans une telle architecture, la grille du transistor entoure le canal, ce qui permet d'améliorer le contrôle électrostatique du canal réalisé par la grille.

Dans un transistor GAAFET, le canal est formé par la superposition de plusieurs nanofils ou nano-couches, chacun entouré par la grille. Cette configuration a pour avantage d'offrir un bon compromis entre le contrôle électrostatique du canal par la grille et le courant de commande obtenus.

Un matériau cristallin déformé mécaniquement correspond à un matériau qui a son ou ses paramètre(s) de maille cristalline allongé(s) ou écourté(s). Dans le cas où le paramètre de maille déformé est plus important que le paramètre dit « naturel » du matériau cristallin, celui-ci est dit en déformation en tension. Lorsque le paramètre de maille déformé est plus petit que le paramètre de maille naturel, le matériau est dit en déformation compressive ou en compression.

A ces états de déformation mécanique d'un matériau cristallin, on associe des états de contraintes mécaniques. Pour autant, il est également commun de se référer à ces états de déformation comme des états de contraintes mécaniques. Dans la présente demande, cette notion de déformation (« strain » selon la terminologie anglo-saxonne) est désignée de façon générique par le terme « contrainte ».

Afin d'améliorer les performances d'un transistor, celui-ci peut être réalisé avec un canal contraint, c'est-à-dire dont le semi-conducteur formant le canal comporte une contrainte. Cette contrainte peut avoir un caractère uni-axial et être orientée parallèlement à la longueur du canal (c'est-à-dire la dimension du canal qui est sensiblement parallèle à la direction de circulation du courant dans le canal), ou un caractère bi-axial, c'est-à-dire être orientée selon deux droites sensiblement perpendiculaires l'une par rapport à l'autre et dont l'une est parallèle à la longueur du canal et l'autre est parallèle à la largeur du canal (c'est-à-dire la dimension du canal qui est, dans le plan principal de la couche dans laquelle est formé le canal, sensiblement perpendiculaire à la direction de circulation du courant dans le canal).

Dans un transistor de type P, une contrainte compressive, ou contrainte en compression, appliquée sur le canal, permet d'améliorer la mobilité des porteurs de charges. Dans un transistor de type N, c'est une contrainte en tension dans le canal qui permet d'améliorer la mobilité des porteurs de charges.

Une telle contrainte dans le canal du transistor peut être apportée par les régions de source et de drain de ce transistor. En effet, en réalisant les régions de source et de drain du transistor avec un semi-conducteur ayant un paramètre de maille différent de celui du semi-conducteur formant le canal, une contrainte en tension ou en compression peut être générée dans le canal.

Dans le cas de transistors de type P à canaux de silicium, les régions de source et de drain de ces transistors peuvent ainsi être réalisées par épitaxie de SiGe qui présente un paramètre de maille plus important que celui du silicium utilisé dans les canaux des transistors. Plus la concentration en germanium dans le SiGe est importante, plus la différence de paramètres de mailles entre le silicium des canaux et ce SiGe des régions de source et de drain est importante, et donc plus la contrainte en compression générée dans les canaux sera importante. Dans le cas de transistors de type N à canaux de silicium, les régions de source et de drain peuvent être réalisées à partir de silicium dopé par des atomes de carbone (Si:C) qui présente un paramètre de maille plus petit que celui du silicium des canaux, engendrant ainsi une contrainte en tension dans les canaux.

Pour que cette contrainte se retrouve de manière optimale dans les canaux des transistors, les régions de source et de drain sont réalisées par épitaxie avec le moins de défauts possible. En effet, la présence de défauts dans la structure cristalline du semi-conducteur des régions de source et de drain tend à induire une relaxation de la contrainte générée dans ces régions, conduisant à ce qu'au moins une partie de l'énergie élastique de cette contrainte soit perdue et ne se retrouve pas dans le canal.

Or, dans le cas de transistors GAAFET, l'épitaxie des régions de source et de drain est réalisée depuis les surfaces de plusieurs portions de silicium distinctes, à savoir les extrémités des nanofils qui sont espacés les uns des autres, et également depuis le substrat. Ces multiples fronts de croissance tendent à former un matériau semi-conducteur défectueux et non monocristallin cohérent avec celui des canaux et du substrat. Une contrainte générée à partir d'une différence de paramètre de maille entre le semi-conducteur des régions de source et de drain et celui du canal ne peut donc pas être obtenue dans ce cas.

De plus, lorsque le substrat ne forme pas une surface de croissance lors de l'épitaxie des régions de source et de drain, comme c'est le cas par exemple pour des transistors GAAFET ou FinFET réalisés sur un substrat de type semi-conducteur sur isolant (par exemple SOI ou « Silicon-On-Insulator ») ou sur un substrat massif comprenant une isolation électrique présente sous les régions de source et de drain, le substrat ne forme pas une surface de croissance pour l'épitaxie du fait que c'est la couche diélectrique enterrée, ou BOX (« Buried OXide »), ou l'isolation électrique destinée à être présente sous les régions de source et de drain, du substrat qui est présente en surface, au niveau des régions de source et de drain. La croissance réalisée depuis le ou les fronts cristallins formés uniquement des surfaces des extrémités des nanofils (pour un transistor GAAFET) ou de la portion (ou aileron) formant le canal (pour un transistor FinFET) s'opère en suivant des directions (le long de l'axe selon lequel s'étend les canaux) dites a surfaces libres, c'est-à-dire que le semi-conducteur formé par cette croissance n'impose pas une contrainte directement selon cet axe ou cette direction.

Un problème analogue se pose également lors de la réalisation de transistors VFET dans lesquels les portions de semi-conducteur formant les canaux et les régions de source et de drain sont réalisées par des épitaxies successives orientées perpendiculairement à la surface du substrat sur lequel ces transistors sont réalisés. La présence d'une surface libre le long de la direction de croissance du semi-conducteur de ces portions réduit fortement l'effet de contrainte recherché en utilisant des semi-conducteurs de paramètres de maille différents entre le semi-conducteur du canal et celui des régions de source et de drain. La croissance de semi-conducteurs présentant des paramètres de maille différents dans la structure verticale d'un tel transistor peut entraîner toutefois des déformations du canal dans le plan parallèle au substrat sur lequel le transistor est réalisé, ce qui se traduit par l'apparition de déformations dans le canal dans la direction vertical de transport de charges. Ces déformations sont toutefois limitées par rapport à celles qui seraient obtenues et engendrées en raison d'un effet direct long de la direction verticale de la différence de paramètres de maille.

### EXPOSÉ DE L'INVENTION

Un but de la présente invention est de proposer un procédé de réalisation d'au moins un transistor FET à canal contraint ne présentant pas les inconvénients des procédés précédemment décrit, c'est-à-dire permettant d'obtenir une contrainte suffisante au sein du canal du transistor, et cela quelle que soit l'architecture du transistor, notamment du type GAA-FET, FinFET ou VFET, et quelle que soit la nature de la surface du substrat sur laquelle le transistor est réalisé.

Pour cela, la présente invention propose un procédé de réalisation d'au moins un transistor FET conformément à la revendication 1.

Dans ce procédé, un matériau semi-conducteur dont la structure cristalline est apte à être modifiée lorsqu'il est soumis à un traitement thermique est utilisé pour former les deuxièmes portions semi-conductrices qui sont destinées à former les régions de source et de drain du transistor. Cette aptitude à avoir une structure cristalline, ou un paramètre de maille, modifiable via la mise en œuvre d'un traitement thermique, est utilisée ici judicieusement car elle permet de faire naître la contrainte après avoir formé les deuxièmes portions semi-conductrices et notamment après que les extrémités de ces deuxièmes portions semi-conductrices opposées à celles se trouvant du côté du canal soient en contact avec des surfaces d'appui. En effet, c'est le traitement thermique mis en œuvre après la réalisation des deuxièmes portions semi-conductrices qui permet de déclencher la modification de la structure cristalline du matériau semi-conducteur. Le paramètre de maille du matériau semi-conducteur des deuxièmes portions semi-conductrices est donc modifié par le traitement thermique, provoquant une modification du volume des deuxièmes portions semi-conductrices et créant ainsi une contrainte dans le canal en raison de l'expansion ou de la contraction du matériau semi-conducteur des deuxièmes portions semi-conductrices engendrée par la modification du paramètre de maille du matériau semi-conducteur.

L'invention s'applique à toutes les architectures de transistors dites 3D, notamment de type GAAFET, FinFET ou VFET.

Avant la mise en œuvre du traitement thermique, le matériau semi-conducteur des deuxièmes portions semi-conductrices peut être dans un état métastable. Dans ce cas, la mise en œuvre du traitement thermique déclenche un changement d'état du matériau semi-conducteur qui passe dans un état de plus grande stabilité.

L'expression « état métastable » désigne un état présentant une stabilité apparente qui ne correspond n'est pas à l'état de plus faible énergie ou l'état le plus stable thermodynamiquement.

En variante, la modification de la structure cristalline du matériau semi-conducteur peut correspondre à un changement de phase du matériau semi-conducteur.

Le matériau semi-conducteur des deuxièmes portions semi-conductrices comporte au moins un élément chimique apte à précipiter lors de la mise en œuvre du traitement thermique. Cet élément chimique apte à précipiter peut être à l'origine de l'état de métastabilité du matériau semi-conducteur. Par exemple, le matériau semi-conducteur peut comporter un premier élément chimique majoritairement présent dans le matériau semi-conducteur et conférant le caractère semi-conducteur à ce matériau, et un deuxième élément chimique apte à précipiter lors de la mise en œuvre du traitement thermique et dont les atomes se substituent à certains atomes du premier élément chimique. Le paramètre de maille du matériau semi-conducteur obtenu est plus petit que celui qui serait obtenu avec uniquement le deuxième élément chimique dans le matériau semi-conducteur. La mise en œuvre du traitement thermique engendre la précipitation des atomes du deuxième élément chimique, ce qui a pour conséquence que ces atomes deviennent interstitiels et que le paramètre de maille du matériau semi-conducteur prend la valeur du paramètre de maille naturel du premier élément chimique.

L'élément chimique apte à précipiter et présent dans le matériau semi-conducteur est choisi tel qu'il est précipité lorsque les deuxièmes portions semi-conductrices sont soumises au traitement thermique, c'est-à-dire exposées à une montée en température importante.

Le procédé est, selon une première configuration, tel que :
- le matériau semi-conducteur des deuxièmes portions semi-conductrices comporte du silicium ou du SiGe,
- l'élément chimique apte à précipiter lors de la mise en œuvre du traitement thermique comporte du carbone, et
- le transistor FET réalisé est de type P.

Dans ce cas, lors de la réalisation des deuxièmes portions semi-conductrices, les atomes de carbone se substituent à certains atomes du silicium ou du SiGe dans le matériau semi-conducteur. Le paramètre de maille du matériau semi-conducteur, qui correspond à du Si:C ou du SiGe:C, est plus petit que celui du silicium ou du SiGe sans carbone. La mise en œuvre du traitement thermique engendre la précipitation des atomes de carbone qui deviennent interstitiels, et le paramètre de maille du matériau semi-conducteur prend la valeur du paramètre de maille naturel du silicium ou du SiGe. On peut alors obtenir une mise en compression du canal

Le pourcentage atomique de carbone dans le matériau semi-conducteur peut être compris entre environ 1 % et 3 %.

En variante, le procédé est, selon une deuxième configuration, tel que :
- le matériau semi-conducteur des deuxièmes portions semi-conductrices peut comporter du germanium,
- l'élément chimique apte à précipiter lors de la mise en œuvre du traitement thermique comporte de l'étain, et
- le transistor FET réalisé est de type N.

Dans ce cas, lors de la réalisation des deuxièmes portions semi-conductrices, les atomes d'étain se substituent à certains atomes de germanium dans le matériau semi-conducteur. Le paramètre de maille du matériau semi-conducteur, qui correspond à du GeSn, est plus petit que celui du germanium sans étain. La mise en œuvre du traitement thermique engendre la précipitation des atomes d'étain qui deviennent interstitiels, et le paramètre de maille du matériau semi-conducteur prend la valeur du paramètre de maille naturel du germanium. On peut alors obtenir une mise en tension du canal.

La modification de la structure cristalline du GeSn engendrée par la mise en œuvre du traitement thermique peut être vue comme correspondant à un changement de phase de l'étain présent dans le GeSn.

Les deuxièmes portions semi-conductrices peuvent être réalisées par épitaxie.

Dans ce cas, lorsque le transistor FET est de type P, l'épitaxie formant les deuxièmes portions semi-conductrices peut réaliser en outre un dopage du matériau semi-conducteur des deuxièmes portions semi-conductrices.

L'étape de traitement thermique peut être mise en œuvre à une température comprise entre environ 700°C et 1050°C et/ou pendant une durée comprise entre environ 1 seconde et 10 minutes.

Lorsque le transistor réalisé est de type GAAFET, la réalisation de la première portion semi-conductrice comporte la mise en œuvre des étapes suivantes :
- gravure d'un empilement de couches disposé sur un substrat et comprenant au moins une couche d'un premier matériau semi-conducteur destiné à former la première portion semi-conductrice, disposée entre le substrat et au moins une couche d'un deuxième matériau semi-conducteur différent du premier matériau semi-conducteur et apte à être gravé sélectivement vis-à-vis du premier matériau semi-conducteur, formant au moins un empilement de nanofils comprenant au moins un nanofil du deuxième matériau semi-conducteur disposé entre le substrat et au moins un nanofil du premier matériau semi-conducteur,
- réalisation d'au moins une grille factice et d'espaceurs externes entre lesquels est disposée la grille factice, recouvrant au moins une partie de l'empilement de nanofils formée de portions des nanofils des premier et deuxième matériaux semi-conducteurs,
- gravure de l'empilement de nanofils telle que seule ladite partie de l'empilement de nanofils soit conservée,
- retrait de parties de la portion du nanofil du deuxième matériau semi-conducteur recouvertes par les espaceurs externes, formant des cavités localisées sous les espaceurs externes,
- dépôt d'au moins un matériau diélectrique dans les cavités, formant des espaceurs internes,
dans lequel les deuxièmes portions semi-conductrices sont réalisées par épitaxie après la réalisation de la première portion semi-conductrice,
et comportant en outre, après la mise en œuvre du traitement thermique :
- dépôt d'un matériau diélectrique encapsulant les deuxièmes portions semi-conductrices,
- retrait de la grille factice,
- réalisation d'une grille entre les espaceurs externes et autour de la première portion semi-conductrice.

Les étapes mises en œuvre peuvent former plusieurs transistors FET disposés les uns à côté des autres tels que certaines des deuxièmes portions semi-conductrices forment des régions de source et de drain communes à des transistors FET voisins deux à deux.

En variante, lorsque le transistor réalisé est de type VFET, les étapes de réalisation des première et deuxièmes portions semi-conductrices comportent la mise en œuvre des étapes suivantes :
- épitaxie de l'une des deuxièmes portions semi-conductrices sur un substrat, puis
- épitaxie de la première portion semi-conductrice sur ladite une des deuxièmes portions semi-conductrices, puis
- épitaxie de l'autre des deuxièmes portions semi-conductrices sur la première portion semi-conductrice,
et dans lequel le traitement thermique est mis en œuvre après un dépôt d'au moins un matériau diélectrique encapsulant les deuxièmes portions semi-conductrices et formant au moins une première des surfaces d'appui, ou après la réalisation de contacts électriques reliés aux deuxièmes portions semi-conductrices et formant au moins la première des surfaces d'appui, une deuxième des surfaces d'appui étant formée par le substrat.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 à 8 représentent schématiquement les étapes d'un procédé de réalisation de transistors FET à canal contraint, objet de la présente invention, selon un premier mode de réalisation ;
- la figure 9 représente schématiquement un transistor obtenu en mettant en œuvre un procédé de réalisation de transistor FET à canal contraint, objet de la présente invention, selon un deuxième mode de réalisation ;
- les figures 10 et 11 représentent schématiquement un transistor obtenu en mettant en œuvre un procédé de réalisation de transistor FET à canal contraint, objet de la présente invention, selon un troisième mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

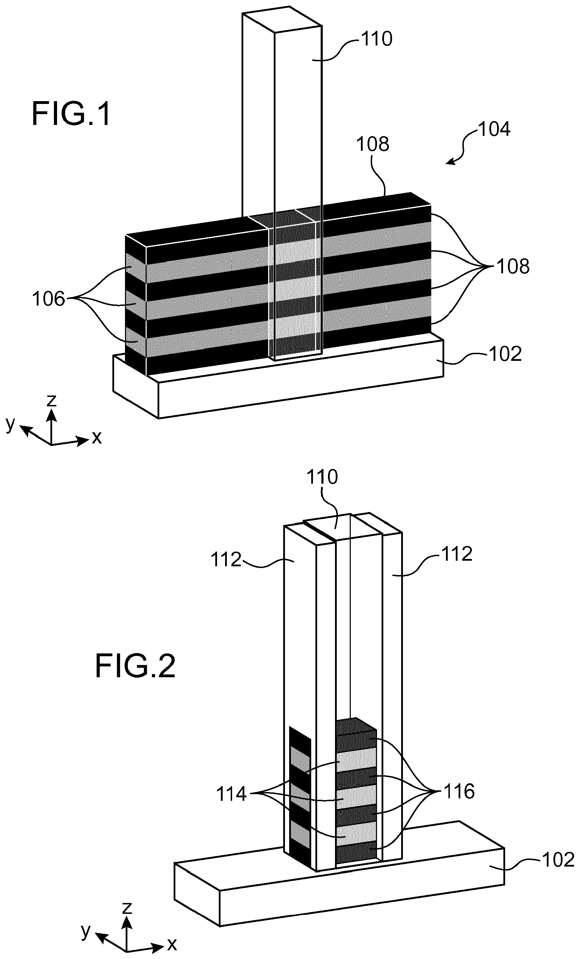

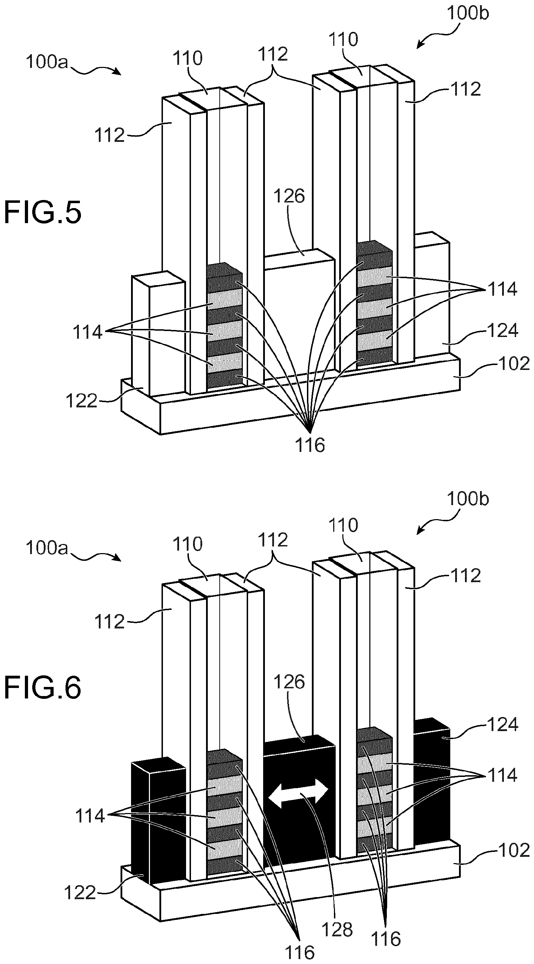

Les figures 1 à 8 représentent les étapes mises en œuvre pour la réalisation de transistors FET 100 à canal contraint selon un premier mode de réalisation. Dans ce premier mode de réalisation, les transistors 100 réalisés sont des transistors GAAFET de type P. Bien que sur les figures 1 à 4 un seul transistor 100 soit représenté, ce procédé est ici mis en œuvre pour réaliser plusieurs transistors 100 reliés électriquement en série et tels qu'au moins une des régions de source et de drain soit commune à deux transistors 100 réalisés l'un à côté de l'autre, comme cela est visible sur les figures 5 à 8.

Les transistors 100 sont réalisés à partir d'un empilement de couches de deux matériaux semi-conducteurs cristallins différents déposées sur un substrat 102. Dans le premier mode de réalisation décrit ici, le substrat 102 correspond à un substrat massif, ou « bulk », de semi-conducteur, par exemple de silicium, sur lequel est disposé l'empilement comprenant des premières et deuxièmes couches formées des deux matériaux semi-conducteurs différents et disposées de manière alternée les unes au-dessus des autres. L'empilement comporte au moins une première couche d'un premier matériau semi-conducteur disposée sur au moins une deuxième couche d'un deuxième matériau semi-conducteur, cette deuxième couche étant disposée entre la première couche et le substrat 102. Chacune des premières couches est destinée à former des nanofil de semi-conducteur servant à former les canaux des transistors 100. Dans le premier mode de réalisation décrit ici, chacune des premières couches est disposée entre deux deuxièmes couches.

En outre, le deuxième matériau semi-conducteur est apte à être gravé sélectivement par rapport au premier matériau semi-conducteur ainsi que par rapport aux matériaux des espaceurs externes et internes. Dans le premier mode de réalisation décrit ici, cet empilement comporte trois premières couches ainsi que quatre deuxièmes couches disposées de manière alternée telles que chacune des premières couches soit disposée entre deux deuxièmes couches.

Les premiers et deuxièmes matériaux semi-conducteurs sont ici cristallins et formés par épitaxie sur le substrat 102. Dans l'exemple décrit ici, le substrat 102 et les premières couches comportent du silicium, et les deuxièmes couches comportent du SiGe avec une proportion de germanium par exemple comprise entre environ 20 % (Si_{0,8}Ge_{0,2}) et 50 % (Si_{0,5}Ge_{0,5}).

En variante, le substrat utilisé peut correspondre à un substrat de type semi-conducteur sur isolant, par exemple SOI (silicium sur isolant), avec dans ce cas la couche superficielle, ou couche mince, du substrat SOI qui peut former l'une des deuxièmes couches de l'empilement. Dans le premier mode de réalisation décrit ici dans lequel les deuxièmes couches comportent du SiGe, un substrat de type SiGeOI peut être utilisé, ce substrat SiGeOI pouvant être réalisé à partir d'un substrat SOI.

Chacune des premières et deuxièmes couches a par exemple une épaisseur comprise entre environ 5 nm et 9 nm.

L'empilement de couches comprenant les premières et deuxièmes couches est gravé sous la forme de portions allongées telles que celle représentée sur la figure 1 et formant un empilement 104 de nanofils disposé sur le substrat 102.

Les portions issues des premières couches forment des premiers nanofils 106 du premier matériau semi-conducteur et les portions issues des deuxièmes couches forment des deuxièmes nanofils 108 du deuxième matériau semi-conducteur. Sur l'exemple de la figure 1, l'empilement 104 comporte trois premiers nanofils 106 chacun disposé entre deux deuxièmes nanofils 108.

La largeur de l'empilement 104, qui correspond à la dimension de l'empilement parallèle à l'axe Y visible sur la figure 1, est égale à la largeur souhaitée des premiers nanofils 106 destinés à former les canaux des transistors 100, et donc égale à la largeur des canaux souhaitée.

Une grille factice 110 est ensuite réalisée, par exemple par lithographie et gravure, sur l'empilement 104, à l'emplacement destiné à la réalisation de la future grille de chacun des transistors 100. Sur la figure 2, une seule grille factice 110 est représentée. La grille factice 110 est formée sur une partie de l'empilement 104 formée de portions des premiers nanofils 106 destinées à former le canal du transistor 100, et de portions des deuxièmes nanofils 108 entre lesquels se trouvent lesdites portions des premiers nanofils 106, et recouvre également des flancs latéraux (au niveau des faces de l'empilement 104 parallèles au plan (X,Z)) de ces portions des nanofils 106, 108.

Des espaceurs externes 112 sont ensuite réalisés, par exemple par dépôt et gravure, sur l'empilement 104, et contre des flancs latéraux de chacune des grilles factices 110. Ces espaceurs externes 112 recouvrent des parties des premiers nanofils 106 destinées à former des régions d'extension de source et de drain des transistors 100. La longueur, ou profondeur, de ces espaceurs externes 112 (dimension parallèle à l'axe X représenté sur la figure 2) est par exemple comprise entre environ 3 et 8 nm. Les espaceurs externes 112 sont destinés à isoler les grilles (qui seront réalisées à une étape ultérieure du procédé) vis-à-vis des régions de source et drain de chacun des transistors 100.

La grille factice 110 comporte par exemple du silicium amorphe ou polycristallin, et les espaceurs externes 112 comportent par exemple du SiN et/ou du Si₃N₄ et/ou du SiBCN.

Les parties de l'empilement 102 non recouvertes par la grille factice 110 et par les espaceurs externes 112 sont ensuite gravées (voir la figure 2), par exemple lors de la gravure des espaceurs externes 112. Des portions restantes 114 des premiers nanofils 106 sont destinées à former les canaux des transistors 100 et forment des premières portions semi-conductrices. Chacune des portions 114 est interposée entre deux portions restantes 116 des deuxièmes nanofils 108. Les portions restantes 114 et 116 ont chacune une forme correspondant à celle d'un nanofil (de longueur inférieure à celle des nanofils initiaux 106, 108).

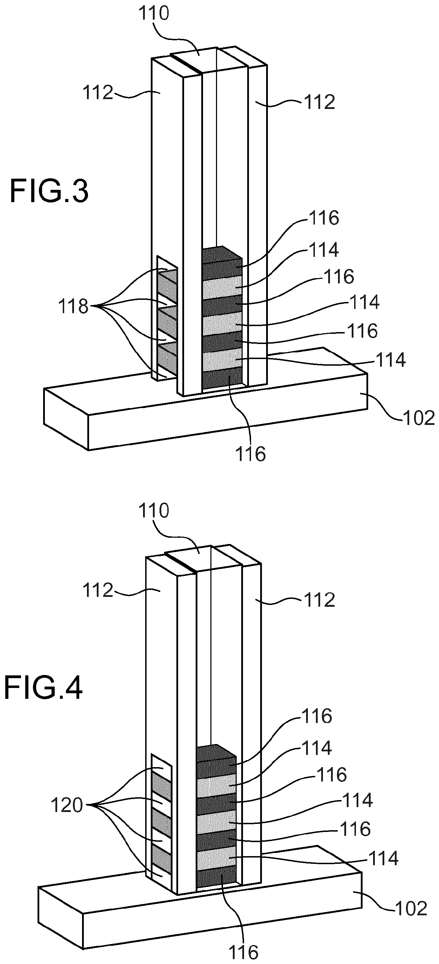

Des cavités 118 peuvent être ensuite réalisées sous les espaceurs externes 112 en gravant une partie (quelques nanomètres selon la direction parallèle à la longueur des nanofils 116, 114, par exemple entre environ 3 nm et 8 nm) des portions restantes 116 depuis les extrémités de ces portions (voir la figure 3).

Des espaceurs internes 120 sont ensuite réalisés dans les cavités 118, en déposant un matériau diélectrique dans ces cavités 118 (voir la figure 4).

Les régions de source et de drain des transistors 100 sont ensuite réalisées par épitaxie depuis les extrémités des portions restantes 114 ainsi que depuis le substrat 102 lorsque la face supérieure du substrat 102 sur laquelle se trouve les portions restantes 114, 116 forme une surface de semi-conducteur depuis laquelle le semi-conducteur des régions de source et de drain peut croître par épitaxie. En variante, lorsque les transistors 100 sont réalisés à partir d'un substrat de type semi-conducteur sur isolant, c'est-à-dire tel que l'empilement 104 soit disposé sur la couche diélectrique enterrée de ce substrat, l'épitaxie n'est mise en œuvre que depuis les extrémités des portions restantes 114, le substrat ne formant pas un front de croissance depuis lequel le semi-conducteur des régions de source et de drain peut croître. Sur la figure 5, une région de source 122 est représentée et correspond à celle du transistor 100a visible sur la partie gauche de cette figure. Une région de drain 124 est également représentée et correspond à celle du transistor 100b visible sur la partie droite de cette figure. Enfin, cette épitaxie forme également une région 126 commune aux deux transistors 100a, 100b, formant à la fois la région de drain du transistor 100a et la région de source du transistor 100b. Ces régions de source et de drain 122, 124, 126 correspondent des deuxièmes portions semi-conductrices.

Cette épitaxie est mise en œuvre telle que les régions de source et de drain 122, 124, 126 comportent au moins un matériau semi-conducteur dont la structure cristalline est apte à être modifiée lorsqu'il est soumis ultérieurement à un traitement thermique. Cette aptitude d'avoir une structure cristalline modifiable via la mise en œuvre d'un traitement thermique est par exemple obtenue du fait que le matériau semi-conducteur est réalisé dans un état métastable. Un tel matériau semi-conducteur correspond par exemple à du silicium dopé par des atomes de carbone (Si:C) ou du SiGe dopé par des atomes de carbone (SiGe:C). Dans ces exemples de matériaux semi-conducteurs, le carbone est présent avec une proportion, ou pourcentage atomique, par exemple compris entre environ 1 % et 3 %. Dans l'exemple de réalisation décrit ici dans lequel les transistors 100 réalisés correspondent à des transistors de type P à canaux de silicium, une épitaxie de SiGe:C ou de Si:C est mise en œuvre pour former les régions de source et de drain 122, 124, 126.

Ce matériau semi-conducteur est de préférence également dopé in situ, par exemple par des atomes de bore, afin de lui conférer la conductivité souhaitée en fonction du type de transistor réalisé, ici un dopage P pour un transistor de type P.

En effet, lors de la réalisation des régions de source et de drain 122, 124, 126 par épitaxie, les atomes de carbone présents dans le matériau semi-conducteur de ces régions se substituent à certains atomes du semi-conducteur, ce qui implique que le paramètre de maille du matériau semi-conducteur est plus petit que celui du semi-conducteur seul sans les atomes de carbone. Un traitement thermique est ensuite mis en œuvre afin que le carbone dans les exemples décrits ci-dessus, précipite. Cette précipitation a pour conséquence que le paramètre de maille du matériau semi-conducteur change et prend la valeur du paramètre de maille naturel de l'élément chimique semi-conducteur utilisé pour former le matériau semi-conducteur sans le carbone. Dans l'exemple de réalisation décrit ici, le traitement thermique a pour effet que le volume du SiGe:C ou du Si:C des régions de source et de drain 122, 124, 126 augmente et apporte ainsi une contrainte en compression dans les canaux formés par les portions 114. Sur la figure 6, cette contrainte en compression est représentée symboliquement par la double flèche 128.

Dans l'exemple de réalisation décrit ici, la région 126 est commune aux deux transistors 100a, 100b visibles et est disposée entre les portions 114, 116 des deux transistors 100a, 100b. Ainsi, les extrémités de la région 126 sont en appui contre ces portions 114, 116 des deux transistors 100a, 100b qui forment donc des surfaces d'appui. Du fait que les régions 122, 124 soient également des régions communes à d'autres transistors voisins des deux transistors 100 réalisés ici, les extrémités des régions 122, 124 sont également en appui contre les portions de semi-conducteur destinées à servir à la réalisation des canaux de ces transistors voisins (non visibles sur les figures 1 à 8). Le fait que les extrémités des régions 122, 124, 126 sont disposées contre des surfaces d'appui contribue à la création de la contrainte au sein de ces régions car si les extrémités de ces régions se trouvaient face à des surfaces libres, la modification du paramètre de maille au sein de ces régions ne se traduirait pas par la création d'une contrainte dans les canaux aussi importante que dans le cas présent.

La température de mise en œuvre du traitement thermique pour déclencher la précipitation de l'élément chimique dont les atomes se substituent à ceux du semi-conducteur dépend de la nature de cet élément chimique et également de la proportion de cet élément chimique dans le matériau semi-conducteur. Dans les exemples de matériaux semi-conducteurs précédemment décrits (Si:C et SiGe:C), plus la concentration en éléments carbone dans le matériau semi-conducteur est importante, plus la température déclenchant la précipitation des éléments carbone peut être faible. A titre d'exemple, la température à laquelle le traitement thermique est mis en œuvre est par exemple comprise entre environ 700°C et 1050°C, pendant une durée comprise entre environ 1 seconde et 10 minutes. Ce traitement thermique peut être mis en œuvre dans un four, un équipement de type RTP (« Rapid Thermal Processing ») ou RTA (« Rapid Thermal Annealing »), etc.

Dans le procédé décrit précédemment, le traitement thermique déclenchant la précipitation de l'élément chimique dont les atomes sont substitutionnels dans le matériau semi-conducteur est mis en œuvre juste après l'épitaxie formant ce matériau semi-conducteur. Pour une bonne efficacité, ce traitement thermique peut être mis en œuvre avant la réalisation des grilles définitives des transistors 100.

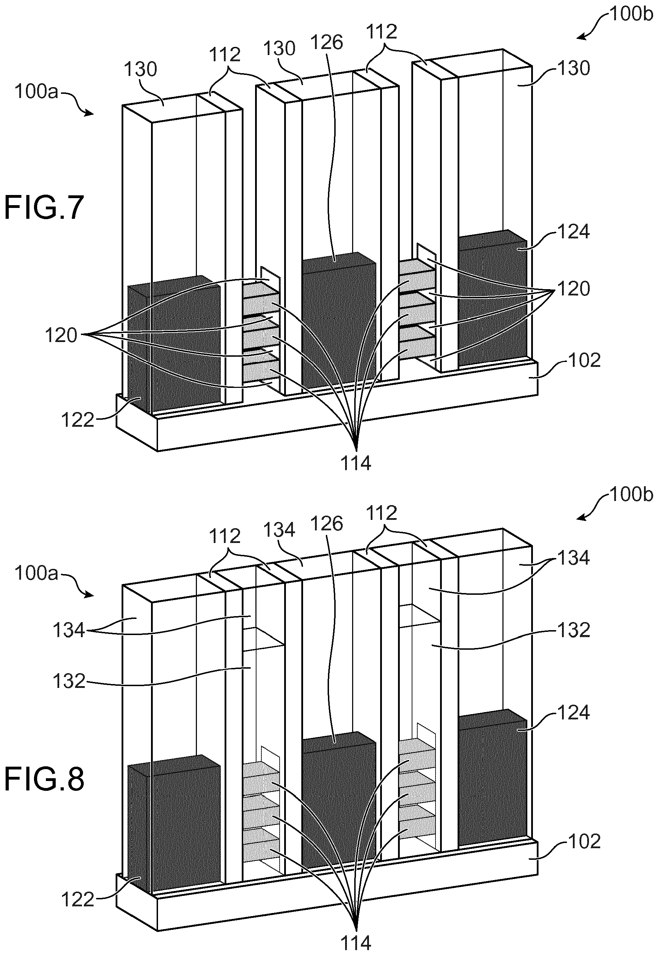

Les transistors FET 100 sont ensuite achevés en encapsulant les régions de source et de drain 122, 124, 126 par un dépôt d'un matériau diélectrique 130 sur et autour de ces régions, puis en gravant les grilles factices 110 et les parties des portions 116 précédemment recouvertes par les grilles factices 110 (figure 7). Des grilles définitives 132, formées chacune d'un diélectrique de grille et d'un matériau conducteur, sont ensuite réalisées dans les emplacements libérés par la gravure des grilles factices 110, puis des contacts électriques 134 des grilles 132 et des régions de source et de drain 122, 124, 126 sont réalisés en déposant un matériau électriquement conducteur sur ces éléments (figure 8).

Le procédé décrit ci-dessus peut également être mis en œuvre pour la réalisation de transistors de type N dans lequel une contrainte en tension du canal est souhaitée. Les portions de semi-conducteur 116 destinées à former les canaux de tels transistors peuvent comporter du germanium, et le matériau semi-conducteur réalisé pour former les régions de source et de drain 122, 124, 126 peut correspondre à du GeSn, l'étain étant dans ce cas l'élément chimique apte à précipiter lors de la mise en œuvre d'un traitement thermique. Ainsi, avant la mise en œuvre du traitement thermique, le GeSn a un paramètre de maille plus important que celui du germanium des canaux des transistors. La mise en œuvre du traitement thermique, par exemple à une température comprise entre environ 700°C et 900°C, engendre alors une précipitation de l'étain présent dans le GeSn. Le paramètre de maille du matériau des régions de source et de drain 122, 124, 126 diminue, créant ainsi une contrainte en tension dans la région de canal des transistors. A titre d'exemple, la température à laquelle le traitement thermique est mis en œuvre dans cette configuration est par exemple comprise entre environ 700°C et 900°C, pendant une durée comprise entre environ 1 seconde et 10 minutes.

Dans le cas de transistors réalisés les uns à côté des autres et reliés en série, des régions de source et de drain sont réalisées de préférence telles qu'elles soient communes à deux transistors adjacents, comme décrit ci-dessus. Toutefois, un matériau semi-conducteur se trouvant dans un état métastable peut également être utilisé pour réaliser les régions de source et de drain d'un ou plusieurs transistors isolés, c'est-à-dire n'ayant pas de régions de source et de drain communes. Dans ce cas, les surfaces d'appui avec lesquelles les extrémités des portions semi-conductrices formant les régions de source et de drain sont formées par le ou les matériaux d'encapsulation formés autour de ces portions semi-conductrices, par exemple du SiN et/ou du SiO₂.

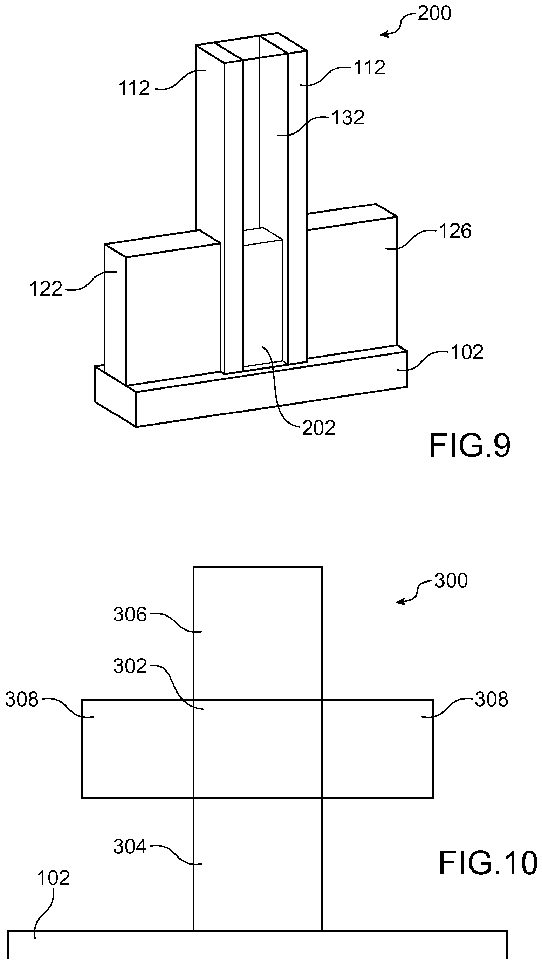

Dans le premier mode de réalisation décrit précédemment, les transistors 100 réalisés sont des transistors GAAFET, c'est-à-dire des transistors dont les canaux sont formés par un ou plusieurs nanofils de semi-conducteur entourés par les grilles. En variante, ce procédé peut s'appliquer pour réaliser des transistors de type FinFET 200, comme celui représenté sur la figure 9. Dans un tel transistor FinFET 200, le canal est formé par une seule portion 202 de semi-conducteur en forme d'aileron et entourée par la grille 132. La contrainte est générée dans cette portion 202 en réalisant les régions de source et de drain 122, 126 comme précédemment décrit pour les transistors GAAFET. Pour réaliser un tel transistor FinFET 200, le matériau formé initialement sur le substrat 102 ne correspond pas à un empilement de couches alternées de deux matériaux semi-conducteurs différents, mais à une seule couche de semi-conducteur. Les étapes précédemment décrites en lien avec les figures 3 et 4 pour former les espaceurs internes 120 ne sont pas mises en œuvre lors de la réalisation de tels transistors FinFET. En outre, l'étape de gravure des portions 114 précédemment mise en œuvre pour la réalisation des transistors GAAFET n'est pas non plus mise en œuvre pour la réalisation des transistors FinFET 200.

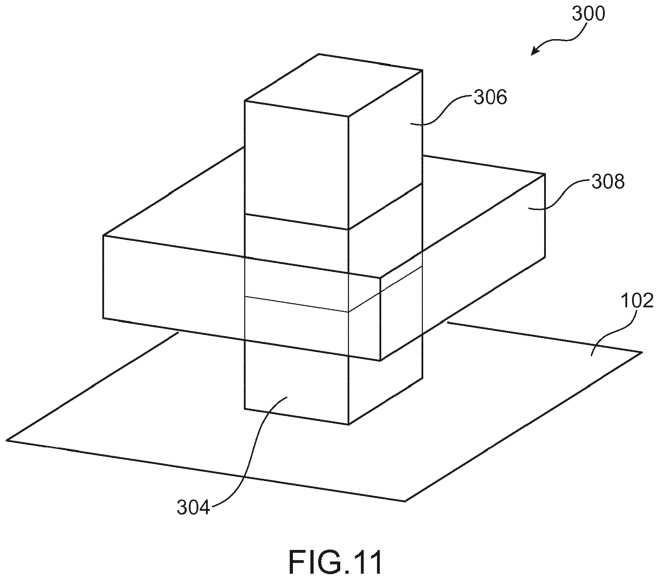

Le procédé décrit précédemment pour former des transistors FET à canal contraint peut également être mis en œuvre pour réaliser des transistors verticaux, appelés transistors VFET 300. Un tel transistor VFET 300 est représenté schématiquement sur les figures 10 et 11.

Le transistor VFET 300 comporte une première portion semi-conductrice 302 formant la région de canal du transistor VFET 300 et interposée entre deux deuxièmes portions semi-conductrices 304, 306 correspondant aux régions de source et de drain du transistor 300. Une grille 308 est formée autour de la première portion semi-conductrice 302. Des contacts électriques, non visibles sur les figures 10 et 11, sont également réalisés pour contacter électriquement la grille 308 et les deuxièmes portions semi-conductrices 304, 306.

Les portions semi-conductrices 302, 304, 306 sont réalisées par la mise en œuvre séquentielle d'étapes d'épitaxie de différents semi-conducteurs sur le substrat 102, par exemple les mêmes que ceux précédemment décrits pour la réalisation des transistors GAAFET 100 (silicium pour la première portion semi-conductrice 302 et Si:C ou SiGe:C pour les deuxièmes portions semi-conductrices 304, 306, ou bien germanium pour la première portion semi-conductrice 302 et GeSn pour les deuxièmes portions semi-conductrices 304, 306, suivant le type N ou P du transistor 300).

Dans un tel transistor VFET 300, l'utilisation d'un matériau semi-conducteur dont la structure cristalline peut être modifiée par la mise en œuvre d'un traitement thermique est avantageuse car après avoir formé une surface d'appui sur la deuxième portion 306, c'est-à-dire contre une extrémité de la deuxième portion 306 opposée à celle en contact avec la première portion semi-conductrice 302, la mise en œuvre du traitement thermique engendrant la précipitation de l'élément chimique dont les atomes passent de l'état substitutionnel à l'état interstitiel, créant une différence de paramètres de mailles qui se traduit par une modification du volume des portions 304, 306 et la création d'une contrainte au sein du canal du transistors VFET 300, via le même phénomène que celui précédemment décrit pour les transistors GAAFET 100 et les transistors FinFET 200. La contrainte créée dans le canal peut être une contrainte en compression dans le cas d'un transistor de type P, ou être une contrainte en tension dans le cas d'un transistor de type N. Les conditions de mise en œuvre du traitement thermique permettant la création de la contrainte dans le canal du transistor 300 peuvent être similaires à celles précédemment décrites pour les transistors GAAFET 100 et les transistors FinFET 200.

## Revendications

1. Procédé de réalisation d'au moins un transistor FET (100a, 100b, 200, 300) comportant au moins la mise en œuvre des étapes suivantes :
- réalisation d'au moins une première portion semi-conductrice (114, 202, 302) destinée à former un canal du transistor FET (100a, 100b, 200, 300),
- réalisation de deuxièmes portions semi-conductrices (122, 124, 126, 304, 306) destinées à former des régions de source et de drain du transistor FET (100a, 100b, 200, 300), telles que la première portion semi-conductrice (114, 202, 302) soit disposée entre des premières extrémités des deuxièmes portions semi-conductrices (122, 124, 126, 304, 306) et que des deuxièmes extrémités des deuxièmes portions semi-conductrices (122, 124, 126, 304, 306), opposées aux premières extrémités, soient en contact avec des surfaces d'appui, et comprenant au moins un matériau semi-conducteur dont la structure cristalline est apte à être modifiée lorsqu'il est soumis à un traitement thermique ;
- traitement thermique engendrant une modification de la structure cristalline du matériau semi-conducteur des deuxièmes portions semi-conductrices (122, 124, 126, 304, 306) et créant une contrainte (128) dans la première portion semi-conductrice (114, 202, 302),
dans lequel le matériau semi-conducteur des deuxièmes portions semi-conductrices (122, 124, 126, 304, 306) comporte au moins un élément chimique apte à précipiter lors de la mise en œuvre du traitement thermique, ledit traitement thermique engendrant la précipitation des atomes dudit élément chimique apte a précipiter, engendrant des atomes interstitiels dudit élément chimique apte a précipiter,
et dans lequel, selon une première configuration :
- le matériau semi-conducteur des deuxièmes portions semi-conductrices (122, 124, 126, 304, 306) comporte du silicium ou du SiGe,
- l'élément chimique apte à précipiter lors de la mise en œuvre du traitement thermique comporte du carbone, et
- le transistor FET (100a, 100b, 200, 300) réalisé est de type P, ou dans lequel, selon une deuxième configuration :
- le matériau semi-conducteur des deuxièmes portions semi-conductrices (122, 124, 126, 304, 306) comporte du germanium,
- l'élément chimique apte à précipiter lors de la mise en œuvre du traitement thermique comporte de l'étain, et
- le transistor FET (100a, 100b, 200, 300) réalisé est de type N.

2. Procédé selon la revendication 1, dans lequel, avant la mise en œuvre du traitement thermique, le matériau semi-conducteur des deuxièmes portions semi-conductrices (122, 124, 126, 304, 306) est dans un état métastable.

3. Procédé selon l'une des revendications précédentes, dans lequel, dans la première configuration, le pourcentage atomique de carbone dans le matériau semi-conducteur est compris entre environ 1 % et 3 %.

4. Procédé selon l'une des revendications précédentes, dans lequel les deuxièmes portions semi-conductrices (122, 124, 126, 304, 306) sont réalisées par épitaxie.

5. Procédé selon la revendication 4, dans lequel, lorsque le transistor FET (100a, 100b, 200, 300) est de type P, l'épitaxie formant les deuxièmes portions semi-conductrices (122, 124, 126, 304, 306) réalise en outre un dopage du matériau semi-conducteur des deuxièmes portions semi-conductrices (122, 124, 126, 304, 306).

6. Procédé selon l'une des revendications précédentes, dans lequel l'étape de traitement thermique est mise en œuvre à une température comprise entre environ 700°C et 1050°C et/ou pendant une durée comprise entre environ 1 seconde et 10 minutes.

7. Procédé selon l'une des revendications précédentes, dans lequel le transistor (100a, 100b, 200, 300) réalisé est de type FinFET ou GAAFET ou VFET.

8. Procédé selon la revendication 7, dans lequel, lorsque le transistor (100a, 100b) réalisé est de type GAAFET, la réalisation de la première portion semi-conductrice (114) comporte la mise en œuvre des étapes suivantes :
- gravure d'un empilement de couches disposé sur un substrat (102) et comprenant au moins une couche d'un premier matériau semi-conducteur destiné à former la première portion semi-conductrice (114), disposée entre le substrat (102) et au moins une couche d'un deuxième matériau semi-conducteur différent du premier matériau semi-conducteur et apte à être gravé sélectivement vis-à-vis du premier matériau semi-conducteur, formant au moins un empilement (104) de nanofils (106, 108) comprenant au moins un nanofil du deuxième matériau semi-conducteur (108) disposé entre le substrat (102) et au moins un nanofil du premier matériau semi-conducteur (106),
- réalisation d'au moins une grille factice (110) et d'espaceurs externes (112) entre lesquels est disposée la grille factice (110), recouvrant au moins une partie de l'empilement (104) de nanofils (106, 108) formée de portions (114, 116) des nanofils des premier et deuxième matériaux semi-conducteurs,
- gravure de l'empilement (104) de nanofils (106, 108) telle que seule ladite partie de l'empilement (104) de nanofils (106, 108) soit conservée,
- retrait de parties de la portion (116) du nanofil du deuxième matériau semi-conducteur recouvertes par les espaceurs externes, formant des cavités (118) localisées sous les espaceurs externes (112),
- dépôt d'au moins un matériau diélectrique dans les cavités (118), formant des espaceurs internes (120),
dans lequel les deuxièmes portions semi-conductrices (122, 124, 126) sont réalisées par épitaxie après la réalisation de la première portion semi-conductrice (114),
et comportant en outre, après la mise en œuvre du traitement thermique :
- dépôt d'un matériau diélectrique (130) encapsulant les deuxièmes portions semi-conductrices (122, 124, 126),
- retrait de la grille factice (110),
- réalisation d'une grille (132) entre les espaceurs externes (112) et autour de la première portion semi-conductrice (114).

9. Procédé selon l'une des revendications précédentes, dans lequel les étapes mises en oeuvre forment plusieurs transistors FET (100a, 100b) disposés les uns à côté des autres et tels que certaines des deuxièmes portions semi-conductrices (126) forment des régions de source et de drain communes à des transistors FET (100a, 100b) voisins deux à deux.

10. Procédé selon la revendication 7, dans lequel, lorsque le transistor (300) réalisé est de type VFET, les étapes de réalisation des première et deuxièmes portions semi-conductrices (302, 304, 306) comportent la mise en œuvre des étapes suivantes :
- épitaxie de l'une des deuxièmes portions semi-conductrices (304) sur un substrat (102), puis
- épitaxie de la première portion semi-conductrice (302) sur ladite une des deuxièmes portions semi-conductrices (304), puis
- épitaxie de l'autre des deuxièmes portions semi-conductrices (306) sur la première portion semi-conductrice (302),
et dans lequel le traitement thermique est mis en œuvre après un dépôt d'au moins un matériau diélectrique encapsulant les deuxièmes portions semi-conductrices (304, 306) et formant au moins une première des surfaces d'appui, ou après la réalisation de contacts électriques reliés aux deuxièmes portions semi-conductrices (304, 306) et formant au moins la première des surfaces d'appui, une deuxième des surfaces d'appui étant formée par le substrat (102).

## Patentansprüche

1. Verfahren zur Realisierung wenigstens eines FET-Transistors (100a, 100b, 200, 300), umfassend wenigstens die Durchführung der folgenden Schritte:
- eine Realisierung wenigstens eines ersten Halbleiterbereichs (114, 202, 302), der dazu ausgelegt ist, einen Kanal des FET-Transistors (100a, 100b, 200, 300) zu bilden,
- eine Realisierung von zweiten Halbleiterbereichen (122, 124, 126, 304, 306), die dazu ausgelegt sind, Source- und Drainregionen des FET-Transistors (100a, 100b, 200, 300) derart zu bilden, dass der erste Halbleiterbereich (114, 202, 302) zwischen ersten Enden der zweiten Halbleiterbereiche (122, 124, 126, 304, 306) angeordnet ist, und dass zweite Enden der zweiten Halbleiterbereiche (122, 124, 126, 304, 306), entgegensetzt zu den ersten Enden, in Kontakt mit Anlageoberflächen sind, und umfassend wenigstens ein Halbleitermaterial, dessen Kristallstruktur modifiziert werden kann, wenn es einer thermischen Behandlung unterzogen wird;
- eine thermische Behandlung, die eine Modifikation der Kristallstruktur des Halbleitermaterials der zweiten Halbleiterbereiche (122, 124, 126, 304, 306) auslöst und eine Verspannung (128) in dem ersten Halbleiterbereich (114, 202, 302) erzeugt,
wobei das Halbleitermaterial der zweiten Halbleiterbereiche (122, 124, 126, 304, 306) wenigstens ein chemisches Element umfasst, das während der Durchführung der thermischen Behandlung ausfällen kann, wobei die thermische Behandlung die Ausfällung der Atome des chemischen Elements auslöst, das ausfällen kann, was Zwischengitteratome des chemischen Elements auslöst, das ausfällen kann,
und wobei gemäß einer ersten Konfiguration:
- das Halbleitermaterial der zweiten Halbleiterbereiche (122, 124, 126, 304, 306) Silizium oder SiGe umfasst,
- das chemische Element, das während der Durchführung der thermischen Behandlung ausfällen kann, Kohlenstoff umfasst, und
- der realisierte FET-Transistor (100a, 100b, 200, 300) vom Typ P ist,
oder wobei gemäß einer zweiten Konfiguration:
- das Halbleitermaterial der zweiten Halbleiterbereiche (122, 124, 126, 304, 306) Germanium umfasst,
- das chemische Element, das während der Durchführung der thermischen Behandlung ausfällen kann, Zinn umfasst, und
- der realisierte FET-Transistor (100a, 100b, 200, 300) vom Typ N ist.

2. Verfahren nach Anspruch 1, bei dem vor der Durchführung der thermischen Behandlung das Halbleitermaterial der zweiten Halbleiterbereiche (122, 124, 126, 304, 306) in einem metastabilen Zustand ist.

3. Verfahren nach einem der vorhergehenden Ansprüche, bei dem in der ersten Konfiguration der Atomprozentsatz von Kohlenstoff in dem Halbleitermaterial zwischen ungefähr 1 % und 3 % enthalten ist.

4. Verfahren nach einem der vorhergehenden Ansprüche, bei dem die zweiten Halbleiterbereiche (122, 124, 126, 304, 306) durch Epitaxie realisiert werden.

5. Verfahren nach Anspruch 4, bei dem, wenn der FET-Transistor (100a, 100b, 200, 300) vom Typ P ist, die Epitaxie, die die zweiten Halbleiterbereiche (122, 124, 126, 304, 306) bildet, ferner eine Dotierung des Halbleitermaterials der zweiten Halbleiterbereiche (122, 124, 126, 304, 306) realisiert.

6. Verfahren nach einem der vorhergehenden Ansprüche, bei dem der Schritt der thermischen Behandlung bei einer Temperatur durchgeführt wird, die zwischen ungefähr 700°C und 1050°C enthalten ist, und/oder während einer Dauer, die zwischen ungefähr 1 Sekunde und 10 Minuten enthalten ist.

7. Verfahren nach einem der vorhergehenden Ansprüche, bei dem der realisierte Transistor (100a, 100b, 200, 300) von Typ FinFET oder GAAFET oder VFET ist.

8. Verfahren nach Anspruch 7, bei dem dann, wenn der realisierte Transistor (100a, 100b) vom Typ GAAFET ist, die Realisierung des ersten Halbleiterbereichs (114) die Durchführung der folgenden Schritte umfasst:
- Ätzen eines Stapels von Schichten, der auf einem Substrat (102) angeordnet ist und wenigstens eine Schicht umfasst aus einem ersten Halbleitermaterial, das dazu ausgelegt ist, den ersten Halbleiterbereich (114) zu bilden, angeordnet zwischen dem Substrat (102) und wenigstens einer Schicht aus einem zweiten Halbleitermaterial, das von dem ersten Halbleitermaterial verschieden ist und hinsichtlich des ersten Halbleitermaterials selektiv geätzt werden kann, wodurch wenigstens ein Stapel (104) von Nanodrähten (106, 108) gebildet wird, umfassend wenigstens einen Nanodraht aus dem zweiten Halbleitermaterial (108), der zwischen dem Substrat (102) und wenigstens einem Nanodraht aus dem ersten Halbleitermaterial (106) angeordnet ist,
- Realisieren von wenigstens einem künstlichen Gate (110) und von externen Abstandhaltern (112), zwischen denen das künstliche Gate (110) angeordnet ist, die wenigstens einen Teil des Stapels (104) von Nanodrähten (106, 108) bedecken, gebildet aus Bereichen (114, 116) der Nanodrähte aus dem ersten und dem zweiten Halbleitermaterial,
- Ätzen des Stapels (104) von Nanodrähten (106, 108) derart, dass nur der Teil des Stapels (104) von Nanodrähten (106, 108) erhalten bleibt,
- Entfernen von Teilen des Bereichs (116) des Nanodrahts aus dem zweiten Halbleitermaterial, die durch die externen Abstandshalter bedeckt sind, wodurch Hohlräume (118) gebildet werden, die unter den externen Abstandhaltern (112) lokalisiert sind,
- Abscheiden wenigstens eines dielektrischen Materials in den Hohlräumen (118), wodurch interne Abstandshalter (120) gebildet werden,
wobei die zweiten Halbleiterbereiche (122, 124, 126) durch Epitaxie nach der Realisierung des ersten Halbleiterbereichs (114) realisiert werden,
und ferner umfassend nach der Durchführung der thermischen Behandlung:
- Abscheiden eines dielektrischen Materials (130), das die zweiten Halbleiterbereiche (122, 124, 126) einkapselt,
- Entfernen des künstlichen Gates (110),
- Realisieren eines Gates (132) zwischen den externen Abstandshaltern (112) und um den ersten Halbleiterbereich (114) herum.

9. Verfahren nach einem der vorhergehenden Ansprüche, bei dem die durchgeführten Schritte mehrere FET-Transistoren (100a, 100b) bilden, die nebeneinander und derart angeordnet sind, dass bestimmte von den zweiten Halbleiterbereichen (126) Source- und Drainregionen bilden, die paarweise benachbarten FET-Transistoren (100a, 100b) gemeinsam sind.

10. Verfahren nach Anspruch 7, bei dem dann, wenn der realisierte Transistor (300) von Typ VFET ist, die Schritte der Realisierung des ersten und des zweiten Halbleiterbereichs (302, 304, 306) die Durchführung der folgenden Schritte umfassen:
- Epitaxie des einen von den zweiten Halbleiterbereichen (304) auf einem Substrat (102), dann
- Epitaxie des ersten Halbleiterbereichs (302) auf dem einen von den zweiten Halbleiterbereichen (304), dann
- Epitaxie des anderen der zweiten Halbleiterbereiche (306) auf dem ersten Halbleiterbereich (302),
und wobei die thermische Behandlung durchgeführt wird nach einer Abscheidung wenigstens eines dielektrischen Materials, das die zweiten Halbleiterbereiche (304, 306) einkapselt und wenigstens eine erste von den Anlageoberflächen bildet, oder nach der Realisierung von elektrischen Kontakten, die mit den zweiten Halbleiterbereichen (304, 306) verbunden sind und wenigstens die erste von den Anlageoberflächen bilden, wobei eine zweite von den Anlageoberflächen durch das Substrat (102) gebildet wird.

## Claims

1. Method of making at least one FET transistor (100a, 100b, 200, 300) including the implementation of at least the following steps:
- fabricate at least a first semiconducting portion (114, 202, 302) intended to form a channel of the FET transistor (100a, 100b, 200, 300),
- fabricate second semiconducting portions (122, 124, 126, 304, 306) intended to form source and drain regions of the FET transistor (100a, 100b, 200, 300), such that the first semiconducting portion (114, 202, 302) is located between first ends of the second semiconducting portions (122, 124, 126, 304, 306) and such that second ends of the second semiconducting portions (122, 124, 126, 304, 306) opposite the first ends, are in contact with bearing surfaces, and comprising at least one semiconducting material for which the crystalline structure can be modified when a heat treatment is applied to it;
- heat treatment generating a modification to the crystalline structure of the semiconducting material of the second semiconducting portions (122, 124, 126, 304, 306) and creating a strain in the first semiconducting portion (114, 202, 302),
Wherein the semiconducting material of the second semiconducting portions (122, 124, 126, 304, 306) comprises at least one chemical element that can be precipitated during application of the heat treatment, said heat treatment causes precipitation of atoms of said chemical element that can be precipitated, creating interstitial atoms of said chemical element that can be precipitated,
and in which, according to a first configuration:
- the semiconducting material of the second semiconducting portions (122, 124, 126, 304, 306) comprises silicon or SiGe,
- the chemical element that can be precipitated during application of the heat treatment comprises carbon, and
- the fabricated FET transistor (100a, 100b, 200, 300) is of the P type,
or in which, according to a second configuration:
- the semiconducting material of the second semiconducting portions (122, 124, 126, 304, 306) comprises germanium,
- the chemical element that can be precipitated during application of the heat treatment comprises tin, and
- the fabricated FET transistor (100a, 100b, 200, 300) is of the N type.

2. Method according to claim 1 in which, before the heat treatment is applied, the semiconducting material of the second semiconducting portions (122, 124, 126, 304, 306) is in a metastable state.

3. Method according to one of previous claims, in which, in the first configuration, the atomic percentage of carbon in the semiconducting material is between about 1% and 3%.

4. Method according to one of the previous claims, in which the second semiconducting portions (122, 124, 126, 304, 306) are fabricated by epitaxy.

5. Method according to claim 4, in which, when the FET transistor (100a, 100b, 200, 300) is of the P type, the epitaxy that forms the second semiconducting portions (122, 124, 126, 304, 306) also dopes the semiconducting material of the second semiconducting portions (122, 124, 126, 304, 306).

6. Method according to one of the previous claims, in which the heat treatment step is applied at a temperature between about 700°C and 1050°C and/or for a duration between about 1 second and 10 minutes.

7. Method according to any one of the previous claims, in which the fabricated transistor (100a, 100b, 200, 300) is of the FinFET or GAAFET or VFET type.

8. Method according to claim 7 in which, when the fabricated transistor (100a, 100b) is of the GAAFET type, fabrication of the first semiconducting portion (114) comprises application of the following steps:
- etch a stack of layers formed on a substrate (102) and comprising at least one layer of a first semiconducting material that will form the first semiconducting portion (114) located between the substrate (102) and at least one layer of a second semiconducting material different from the first semiconducting material and that can be etched selectively relative to the first semiconducting material, forming at least one stack (104) of nanowires (106, 108) comprising at least one nanowire of the second semiconducting material (108) located between the substrate (102) and at least one nanowire of the first semiconducting material (106),
- fabricate at least one dummy gate (110) and external spacers (112) between which the dummy gate (110) is formed, covering at least part of the stack (104) of nanowires (106, 108) formed of portions (114, 116) of the nanowires of the first and second semiconducting materials,
- etch the stack (104) of nanowires (106, 108) such that only said part of the stack (104) of nanowires (106, 108) is kept,
- remove parts of the portion (116) of the nanowire of the second semiconducting material covered by external spacers, forming cavities (118) located under the external spacers (112),
- deposit at least one dielectric material in the cavities (118), forming internal spacers (120),
in which the second semiconducting portions (122, 124, 126) are fabricated by epitaxy after the first semiconducting portion (114) has been fabricated,
and also comprising, after application of the heat treatment:
- deposition of a dielectric material (130) encapsulating the second semiconducting portions (122, 124, 126),
- removal of the dummy gate (110),
- fabrication of a gate (132) between the external spacers (112) and around the first semiconducting portion (114).

9. Method according to one of the previous claims, in which the steps used form several FET transistors (100a, 100b) located adjacent to each other such that some second semiconducting portions (126) form source and drain regions common to adjacent FET transistors (100a, 100b) in pairs.

10. Method according to claim 7, in which, when the fabricated transistor (300) is of the VFET type, the steps to fabricate the first and second semiconducting portions (302, 304, 306) comprise application of the following steps:
- epitaxy of one of the second semiconducting portions (304) on a substrate (102), then
- epitaxy of the first semiconducting portion (302) on said one of the second semiconducting portions (304), then
- epitaxy of the other of the second semiconducting portions (306) on the first semiconducting portion (302),
and in which the heat treatment is applied after deposition of at least one dielectric material encapsulating the second semiconducting portions (304, 306) and forming at least a first of the bearing surfaces, or after the fabrication of electrical contacts connected to the second semiconducting portions (304, 306) and forming at least the first of the bearing surfaces, a second of the bearing surfaces being formed by the substrate (102).
